Europäisches Patentamt

European Patent Office

Office européen des brevets

(11) Publication number: **0 060 783**
**B1**

(12) **EUROPEAN PATENT SPECIFICATION**

(45) Date of publication of patent specification: **18.09.85**

(21) Application number: **82400446.9**

(22) Date of filing: **12.03.82**

(51) Int. Cl.⁴: **C 03 C 3/04,** C 23 C 16/40 //
H01L21/316, H01L21/473,
H05K1/05, H05K3/28

(54) Process of forming a thin glass film on a semiconductor substrate.

(30) Priority: **16.03.81 US 243989**

(43) Date of publication of application:
**22.09.82 Bulletin 82/38**

(45) Publication of the grant of the patent:
**18.09.85 Bulletin 85/38**

(84) Designated Contracting States:
**DE FR GB IT NL**

(56) References cited:
**US-A-3 669 693**
**US-A-4 196 232**

(73) Proprietor: **FAIRCHILD CAMERA &
INSTRUMENT CORPORATION
464 Ellis Street
Mountain View California 94042 (US)**

(72) Inventor: **Lehrer, William I.
1161 Seena Avenue
Los Altos California 94022 (US)**

(74) Representative: **Chareyron, Lucien et al
Schlumberger Limited Service Brevets c/o Giers
12, place des Etats Unis B.P. 121
F-92124 Montrouge Cédex (FR)**

## Description

### Background of the invention
### Field of the invention

This invention relates to a method of forming a thin glass film on a semiconductor substrate by chemical vapor deposition ("CVD") techniques, the glass having a softening (or "flow") point far below temperatures at which glasses currently used in the semiconductor industry flow.

### Description of the prior art

The vapor deposition of phosphorus-doped silicon oxides onto a substrate is well-known. Such glasses are typically used to passivate the surfaces of integrated circuits made using silicon. Commonly denoted as "PVx" or "phosphorus doped vapox", glasses formed in this manner have very high melting points in the range of 1000°C to 1100°C. To reflow these glasses to remove sharp edges and provide curved, gradual-sloping surfaces on which conductive leads can easily be formed with gradual, rather than abrupt, changes in surface height, thereby to reduce the likelihood of such leads cracking or braking, the integrated circuit must be heated to temperatures within the range of 1000° to 1100°C. Such high temperatures change the diffusion profiles of the various doped regions within the integrated circuit which give to the circuit its electrical characteristics. This is undesirable. Thus the fabrication of a semiconductor integrated circuit particularly one using more than one level of conductive leads (known as a "multilevel" structure) becomes highly complicated with the final characteristics of the device differing somewhat from the characteristics of the device prior to the formation of the various levels of conductive leads.

One method of eliminating cracks in glass layers such as phosphosilicate glass layers is depicted in U.S. Patent 4,196,232 to Schnable et al. which is directed to vapor-deposition of a low-stress glass layer with reduced cracks upon reheating to 450°C or to 525°C. A method of forming very thick germania-silica glass layers bonded to silicon wafers by glazing at temperatures from 1300°C to 1400°C or vacuum evaporation at 750°C to 900°C is depicted in U.S. Patent 3,669,693 to Dalton et al., with no mention of surface roughness or reflowing.

The formation of glasses suitable for use as passivating and/or insulating layers in integrated circuits which melt at temperatures significantly below the 1100°C temperatures at which glasses currently used in integrated circuits melt is particularly important now that laser annealing and glass reflow techniques are becoming commonly used in semiconductor processing. In the past, various glass mixtures have been used or proposed to achieve lower melting temperatures. Thus sedimented glasses have been proposed for use in the manufacture of integrated circuits with the constituents of the glasses being selected such that these glasses melt at a substantially lower temperature than the melting temperatures of commonly used phosphorus-doped vapor deposited oxides of silicon. Unfortunately, the techniques used to control the thicknesses of the deposited glasses and the technologies for depositing the glasses differ substantially from the techniques and technologies currently used in the semiconductor industry in the vapor deposition of oxides of silicon (both undoped and doped with phosphorus).

### Summary of the invention

This invention substantially overcomes the above problems by providing a thin glass film suitable for use as insulation in semiconductor devices. The glass of this invention utilizes the same equipment as utilized to form the phosphorus doped vapox of the prior art but produces a glass which has a melting point far below temperatures which cause dopant diffusion problems.

One aspect of the invention is directed to the method of forming a thin glass film characterized by: (a) reacting a gaseous mixture of germane and silane with oxygen at a reaction temperature of from 350°—500°C to form a mixed germanium oxide/silicon oxide vapor; (b) depositing said vapor on a semiconductor substrate as a glass film of less than about 5 microns in thickness; and (c) reflowing the resulting glass film at a temperature range of approximately 700°C to 900°C.

In accordance with this invention, a binary glass is deposited in a CVD (i.e., chemical vapor deposition) reactor from a germane/silane ($GeH_4/SiH_4$) co-deposition source by reacting these two gases at temperatures ranging from approximately 350°C to 500°C with oxygen in a nitrogen carrier gas. The resulting glass (a germanium dioxidesilicon dioxide mixture) has a useful range of flow points typically between approximately 700°C to 900°C thereby making it particularly attractive for use as a dielectric material in multilevel integrated circuit structures.

The addition of phosphorus in the form of phosphorus pentoxide ($P_2O_5$) by blending phosphine ($PH_3$) into the deposition gas stream at a selected percentage by weight results in an excellent passivated glass film which, by controlling the phosphorus level to be relatively low, substantially eliminates corrosion, a common problem in prior art integrated circuits using phosphorous-doped passivation of glass together with aluminum interconnect structures.

### Detailed description of the invention

In accordance with this invention, a mixture of germanium dioxide and silicon dioxide is deposited on an appropriate substrate, such as a silicon wafer used in the manufacture of integrated circuits, in a conventional chemical vapor deposition reactor of a type commonly known and used in the semiconductor industry, from a co-deposition source of germane ($GeH_4$) and silane ($SiH_4$). In a preferred embodiment, the deposition is carried out by reacting these two gases at temperatures ranging from 350°C to 500°C with oxygen in a nitrogen carrier gas. A typical preferred ratio for the deposition of this glass is approximately:

| Constituents | Flow rates |
| --- | --- |
| $GeH_4$ | 3.67 cc/min |
| $SiH_4$ | 7.33 cc/min |
| $O_2$ | 100 cc/min |
| $N_2$ | 2.00 L/min |

where "cc" means cubic centimeters and "L" means liters. The above constituents are reacted at 450°C. Of importance, $GeH_4$ is more reactive than $SiH_4$. Thus, the result of this reaction is a glass film which will, undoped, in a nominal 50—50 mixture by weight, melt at about 850°C when placed in a furnace with nitrogen at this temperature and held at this temperature for 30 minutes.

In a variation of this process, phosphorus pentoxide ($P_2O_5$) is introduced into the gas stream by blending phosphine ($PH_3$) into the gas stream in an amount ranging from three to nine percent (3—9%) by weight. The resulting phosphorus doped glass forms an excellent film and melts between 700° to 900°C.

A characteristic of germanium dioxide ($GeO_3$) is that this material exists in both soluble and relatively insoluble forms in water. When germanium dioxide is grown alone at normal temperatures, the resulting glass is soluble in water. Germane ($GeH_4$) is a commercially available substance supplied by a number of vendors. The germane used in this process is of the quality generally available in the marketplace.

As the percentage of germanium dioxide in the resulting germanium dioxide/silicon dioxide glass mixture increases to above somewhere in the 45—55% range, the resulting binary mixture starts to become relatively more soluble in water than phosphorus-doped silicon dioxide. By holding the percentage by weight of germanium dioxide in the mixture less than between 45—55% by weight, the resulting binary glass film is not significantly more water soluble than phosphorus-doped silicon dioxide (that is, its solubility is on the same order of PVx). Such a binary glass film is substantially insoluble in water. When the percentage by weight of germanium dioxide in the binary glass becomes greater than about 50%, however, the oxide becomes relatively more water soluble.

The addition of phosphorus in the form of $P_2O_5$ in the range of 3% to 9% by weight to the resulting glass lowers the softening temperature of the glass to about 700°C. Without phosphorus, the glass begins to soften at approximately 800°C.

An important feature of the binary glass is that it can be deposited using standard equipment currently used in the semiconductor industry for the deposition of phosphorus doped oxides of silicon. Thus the basic deposition technology and equipment is already available for use in practicing this invention.

By increasing the phosphorus content in the binary glass mixture to 3—9% and heating the glass under 20 atmospheres pressure, the glass has been experimentally flowed at 650°C. This allows glass to be reflowed at a temperature slightly beneath that at which aluminum melts (aluminium melts at about 660°C). Although an aluminum-silicon eutectic melts at 577°C and an aluminum copper eutectic melts at 548°C, the glass of this invention closely approches these melting points thereby, in some instances, making it possible to reflow glass following the deposition of aluminum interconnects without melting the aluminum interconnects. The glass of this invention is particularly suitable for use with localized glass reflow techniques involving the use of lasers wherein local regions of the glass can be reflowed without significantly increasing the temperature of adjacent portions of the semiconductor circuit. Thus, even though the melting temperature of the glass is slightly higher than that of aluminum, with careful control of the areas heated the melting temperature of this glass is sufficiently low that glass can be locally heated and reflowed without melting adjacent regions of aluminum.

Although phase diagrams for germanium dioxide/silicon dioxide mixtures are known for bulk systems, these phase diagrams generally do not apply to the thin films commonly employed in the semiconductor industry. As used herein, the term "thin film" is meant to refer to a film of silicon dioxide/geramium dioxide having a thickness generally less than about 5 microns and typically less than about 2 microns. The thicknesses of films formed using the techniques of this invention for insulation layers in integrated circuits can drop as low several hundred angstroms under proper conditions but more typically range in the thousands of angstroms.

Other embodiments of this invention will be obvious to those skilled in the art in view of the above description. The above description is intended only to be exemplary and not limiting.

## Claims

1. The method of forming a thin glass film characterized by:

(a) reacting a gaseous mixture of germane and silane with oxygen at a reaction temperature of from 350°—500°C to form a mixed germanium oxide/silicon oxide vapor;

(b) depositing said vapor on a semiconductor substrate as a glass film of less than about 5 microns in thickness; and

(c) reflowing the resulting glass film at a temperature range of approximately 700°C to 900°C.

2. The method of claim 1 characterized in that the germane has a flow rate of approximately 3,67 cc/min, the silane has a flow rate of approximately 7,33 cc/min, and the germane and silane are reacted with oxygen in a nitrogen carrier gas wherein the oxygen has a flow rate of approximately 100 cc/min and the nitrogen has a flow rate of approximately 2 liters/min.

3. The method of claim 1 or 2 further characterized by introducing a phosphorus compound into said reacting mixture to provide a resultant phosphorus doped glass film.

4. The method of claim 3 characterized in that said phosphorus doped glass film contain from 3 to 9% by weight of said phosphorus compound.

**Patentansprüche**

1. Verfahren zur Bildung einer dünnen Glasschicht, gekennzeichnet durch

(a) Reagierenlassen einer gasförmigen Mischung von Germaniumwasserstoff und Silan mit Sauerstoff bei einer Reaktionstemperatur von 350—500°C, um einen Dampf aus einen Germaniumoxid/Siliciumoxid-Gemisch zu bilden;

(b) Niederschlagen des besagten Dampfes auf einem Halbleitersubstrat als Glasschicht mit einer Dicke von weniger als 5 μm; und

(c) erneutes Fließenlassen der resultierenden Glasschicht in einem Temperaturbereich von etwa 700°C bis 900°C.

2. Verfahren nach Anspruch 1, dadurch gekennzeichnet, daß der Germaniumwasserstoff eine Durchflußrate von etwa 3,67 cm³/min, das Silan eine Durchflußrate von etwa 7,33 cm³/min besitzen und der Germaniumwasserstoff und das Silan mit Sauerstoff in einem Stickstoffträger gas reagieren, wobei der Sauerstoff eine Durchflußrate von etwa 100 cm³/min und der Stickstoff eine Durchflußrate von etwa 2 Liter/min haben.

3. Verfahren nach Anspruch 1 oder 2, gekennzeichnet durch Einführen einer Phosphorverbindung in die besagte Reaktionsmischung, um eine resultierende phosphordotierte Glassschicht zu liefern.

4. Verfahren nach Anspruch 3, dadurch gekennzeichnet, daß die phosphordotierte Glasschicht von 3 bid 9% Gew.-% der Phosphorverbindung enthält.

**Revendications**

1. Procédé de formation d'un mince film de verre, caractérisé par les étapes suivantes:

(a) faire réagir un mélange gazeux de germane et de silane avec de l'oxygène à une température de réaction de 350° à 500°C pour former une vapeur d'oxyde de germanium et d'oxyde de silicium mélangés;

(b) déposer ladite vapeur sur un substrat semiconducteur sous la forme d'un film de verre de moins de 5 microns d'épaisseur; et

(c) refondre le film de verre résultant dans une plage de température d'environ 700°C à 900°C.

2. Procédé selon la revendication 1, caractérisé en ce que le germane a un débit d'environ 3,67 cc/min. le silane a un débit d'environ 7,33 cc/min. et le germane et le silane réagissent avec l'oxygène dans un gaz porteur formé d'azote, dans lequel l'oxygène a un débit d'environ 100 cc/min et l'azote a un débit d'environ 2 litres/min.

3. Procédé selon la revendication 1 ou 2, caractérisé de plus en ce que l'on introduit un composé de phosphore dans ledit mélange de réaction pour obtenir un film de verre résultant dopé au phosphore.

4. Procédé selon la revendication 3, caractérisé en ce que ledit film de verre dopé au phosphore contient de 3 à 9% en poids dudit composé de phosphore.